# EUROPEAN PATENT APPLICATION

(11) **EP 4 152 901 A1**
(43) Date of publication of application: **22.03.2023**
(21) Application number: 22195696.4
(22) Date of filing: 14.09.2022
(51) Int. Cl.: H05K 3/46, H05K 1/11, H05K 3/40, B81B 7/00, B81C 1/00

(54) **ELECTRONIC DEVICE**

(30) Priority: 16.09.2021 US 202163244930 P
(71) Applicant: PanelSemi Corporation, New Taipei City 231 (TW)
(72) Inventor: LI, Chin-Tang, 231 New Taipei City (TW)
(74) Representative: Zimmermann, Tankred Klaus

(57) **Abstract**

An electronic device with high density for component arrangement includes a first substrate, a second substrate, a plural of passages formed through the first and the second substrates, a first contact arranged on the first face of the first substrate to conceal the corresponding one of the passages, a second contact arranged on the second substrate and adjacent to the corresponding one of the passages, and a conductor disposed in the passages. A first end of the conductor electrically connects the first contact, while a second end of the conductor electrically connects the second contact.

## Description

### BACKGROUND

### Technology Field

The present disclosure relates to an electronic device with high density for component arrangement.

### Description of Related Art

The application of electronic apparatus becomes more diversified, and the use of large apparatus for a mass utility or of multi-functional for a compact-sized apparatus is becoming more and more popular. As it is known of that the difficulties of large-scale apparatus or of compacted apparatus with high-density arrangement results from various facts, including the novel design does not suit for the conventional plants so as to there is a need to build up a new one for advanced technologies, and issues et cetera. A novel electronic device or a method of making the same, which is beneficial of balance and effectivity between the unique and the convention and of flexibility for the diversities of the electronic apparatus trends, is required in urge.

It is to be understood that this background of the technology section is intended to provide useful background for understanding the technology and as such disclosed herein, the technology background section may include ideas, concepts or recognitions that were not part of what was known or appreciated by those skilled in the pertinent art prior to a corresponding effective filing date of subject matter disclosed herein.

### SUMMARY

Embodiments of the present invention are directed to an electronic device being provided for high-density layout and arrangement of components.

Embodiments of the present invention are directed to an electronic device, comprising a first substrate, a second substrate, a plural of passages, a plural of first contacts, a plural of second contacts, and a plural of conductors. The first substrate is defined with a first face and a second face opposite to each other. The second substrate is defined with a first face and a second face opposite to each other. The first face of the second substrate is adjacent to the second face of the first substrate. Each of the passages is defined with a first opening and a second opening opposite to each other. The first opening of one of the passages is formed at the first face of the first substrate, while the second opening of the corresponding one of the passages is formed at the second face of the second substrate. The first contacts are arranged on the first face of the first substrate, and one of the first contacts is concealing the first opening of the corresponding one of the passages. The second contacts are arranged on the second face of the second substrate, and one of the second contacts is adjacent to the second opening of the corresponding one of the passages. The conductors are disposed in the passages, and each of the conductors is defined with a first end and a second end opposite to each other. The first end of one of the conductors electrically connects the corresponding one of the first contacts, while the second end of the corresponding one of the conductors electrically connects the corresponding one of the second contacts.

In one aspect of the embodiment, a plural of electronic components are disposed on the first face of the first substrate, and one of the electronic components electrically connects the corresponding one of the first contacts.

In one aspect of the embodiment, a plural of active members are disposed on the second substrate and electrically connect to the conductors.

In one aspect of the embodiment, the electronic device further comprises an electronic component arranged on the first face of the first substrate, and the electronic component electrically connects the corresponding one of the first contacts.

In one aspect of the embodiment, the electronic component is on or under a level of millimeter or micro-meter scale.

In one aspect of the embodiment, the electronic component is a photoelectrical chip or package.

In one aspect of the embodiment, the quantity of the electronic component is plural.

In one aspect of the embodiment, the first substrate or/and the second substrate is a resilient board, a rigid board, or a composite board including at least one of a resilient board and a rigid board.

In one aspect of the embodiment, the first substrate is of a thickness equal to or less than 0.5 millimeter.

In one aspect of the embodiment, the conductors include a material of tin, copper, silver, or gold, or an alloy or an intermetallic compound including any or any combination of the foregoing materials.

In one aspect of the embodiment, the electronic device further comprises an adjunctive member disposed in the corresponding one of the passages.

In one aspect of the embodiment, the adjunctive member is conductive.

In one aspect of the embodiment, the adjunctive member is a bump disposed at and beneath the corresponding one of the first contacts.

In one aspect of the embodiment, the adjunctive member is a wire.

In one aspect of the embodiment, one of the passages is defined by at least one passage wall, and the adjunctive member is attached onto the passage wall.

In one aspect of the embodiment, the electronic device further comprises an adhesion layer connected between the first substrate and the second substrate.

In one aspect of the embodiment, the adhesion layer includes a material of non-conductive polymer.

In one aspect of the embodiment, the first substrate includes a conductive pattern layer, and ones of the first contacts electrically connect the conductive pattern layer.

In one aspect of the embodiment, the first substrate includes a conductive pattern layer, and ones of the first contacts are partial of the conductive pattern layer.

In one aspect of the embodiment, the first substrate includes a conductive pattern layer, and the conductive pattern layer defines a thickness no greater than 1/4 mil.

In one aspect of the embodiment, one or ones of the first contacts defines a thickness no less than the thickness of the conductive pattern layer.

In one aspect of the embodiment, a gap is defined between a bottom surface of one or ones of the first contacts and a top surface of the first substrate, the bottom surface of one or ones of the first contacts is higher than the top surface of the first substrate in a longitudinal direction along a corresponding one of the passages.

In one aspect of the embodiment, the conductive pattern layer is formed on the first face of the first substrate.

In one aspect of the embodiment, the second substrate includes a conductive trace layer, and ones of the second contacts electrically connect the conductive trace layer.

In one aspect of the embodiment, the second substrate includes a conductive trace layer, and ones of the second contacts are partial of the conductive pattern layer.

In one aspect of the embodiment, one of the conductors is defined with a first diameter portion and a second diameter portion connected to the first diameter portion; the first diameter portion is disposed in a corresponding one of the passages and connects the first pad to the second diameter portion, while the second diameter portion rests on the second face of the second substrate and electrically connects the corresponding one of the second contacts; a diameter of the second diameter portion is equal to or greater than that of the first diameter portion.

In one aspect of the embodiment, one of the second contacts at least partially embraces the second opening of the corresponding one of the passages, and the second diameter portion at least partially covers a corresponding one of the second pads.

In one aspect of the embodiment, the second diameter portion is mushroom-shaped.

In one aspect of the embodiment, the first and second diameter portions are made of the same materials.

In one aspect of the embodiment, the quantity of the first substrate is plural.

In one aspect of the embodiment, the quantity of the adhesion layer is plural, and the adhesion layers correspond to the first substrates and connect between the first substrates and the second substrate.

In one aspect of the embodiment, an active member is disposed on the second substrate and electrically connected to the conductors; and the active member at least partially overlaps the electronic component in a direction vertical to the first substrate.

In one aspect of the embodiment, the quantity of the active member is plural.

Embodiments of the present invention are directed to an electronic device, comprising a first substrate, a second substrate, a plural of passages, a plural of first contacts, a plural of second contacts, a plural of conductors, a plural of electronic components, and a plural of active members. The first substrate is defined with a first face and a second face opposite to each other. The second substrate is defined with a first face and a second face opposite to each other, and the first face of the second substrate is adjacent to the second face of the first substrate. Each of the passages is defined with a first opening and a second opening opposite to each other. The first opening of one of the passages is formed at the first face of the first substrate, while the second opening of the corresponding one of the passages is formed at the second face of the second substrate. The first contacts are arranged on the first face of the first substrate, and one of the first contacts conceals the first opening of the corresponding one of the passages. The second contacts are arranged on the second face of the second substrate, and one of the second contacts is adjacent to the second opening of the corresponding one of the passages. The conductors are disposed in the passages. Each of the conductors is defined with a first end and a second end opposite to each other, and the first end of one of the conductors electrically connects the corresponding one of the first contacts, while the second end of the corresponding one of the conductors electrically connects the corresponding one of the second contacts. The electronic components are disposed on the first face of the first substrate, and one of the electronic components electrically connects the corresponding one of the first contacts. The active members are disposed on the first substrate or/and the second substrate and electrically connect to the conductors.

Embodiments of the present invention are directed to a manufacture method for the foresaid electronic device, comprising a step of providing a first and a second substrates, on which one or more passages formed through the first and the second substrates and one or more first and second pads respectively disposed thereon, and a step of electrically connecting the first and the second substrates. In the step of providing the first and the second substrates, the first substrate is defined with a first face and a second face opposite to each other; the second substrate is defined with a first face and a second face opposite to each other; the first face of the second substrate is adjacent to the second face of the first substrate; each of the passages is defined with a first opening and a second opening opposite to each other; the first opening of one of the passages is formed at the first face of the first substrate, while the second opening of the corresponding one of the passages is formed at the second face of the second substrate; the first contacts are arranged on the first face of the first substrate, and one of the first contacts is concealing the first opening of the corresponding one of the passages; and the second contacts are arranged on the second face of the second substrate, and one of the second contacts is adjacent to the second opening of the corresponding one of the passages. In the step of electrically connecting the first and the second substrates, one or more conductors are disposed in one or more of the passages, and each of the conductors is defined with a first end and a second end opposite to each other; the first end of one of the conductors electrically connects the corresponding one of the first contacts, while the second end of the corresponding one of the conductors electrically connects the corresponding one of the second contacts.

In one aspect of the embodiment, in the step of providing the first and the second substrates, the first and the second substrates are electrically isolated from each other.

In one aspect of the embodiment, in the step of providing the first and the second substrates, the first and the second substrates are connected to each other and then penetrating the first and the second substrates to form the passages.

In one aspect of the embodiment, in the step of providing the first and the second substrates, the first and the second substrates are penetrating together to form the passages by laser processing.

In one aspect of the embodiment, the first and the second substrates are respectively formed with one or more holes and then connected with each other, in which the holes formed on the first substrate and the holes formed on the second substrate are kept aligned with each other to form the passages.

In one aspect of the embodiment, in the step of providing the first and the second substrates, the first and the second substrates are penetrating individually to form the holes by laser processing.

In one aspect of the embodiment, in the step of electrically connecting the first and the second substrates, the conductors are disposed in the passages to electrical connect the first contacts and the second contacts at the same time.

In one aspect of the embodiment, in the step of electrically connecting the first and the second substrates, the conductors are made of one single conductive material.

The foregoing is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

The disclosure will become more fully understood from the detailed description and accompanying drawings, which are given for illustration only, and thus are not limitative of the present disclosure, and wherein:
FIG. 1 showing a side view of an electronic device according to more than one embodiment of this disclosure.
FIGS. 2A to 2C, 2C', and 3 to 5 are embodiments of the electronic device according to this disclosure.

### DETAILED DESCRIPTION OF THE DISCLOSURE

The present disclosure will be apparent from the following detailed description, which proceeds with reference to the accompanying drawings, wherein the same references relate to the same elements.

Advantages and features of the present invention and methods for achieving them will be made clear from embodiments described below in detail with reference to the accompanying drawings. The present invention may, however, be embodied in many different forms and should not be construed as being limited to the embodiments set forth herein. Rather, these embodiments are provided so that this disclosure will be thorough and complete, and will fully convey the scope of the invention to those skilled in the art. The present invention is merely defined by the scope of the claims. Therefore, well-known constituent elements, operations and techniques are not described in detail in the embodiments in order to prevent the present invention from being obscurely interpreted. Like reference numerals refer to like elements throughout the specification.

The spatially relative terms "below", "beneath", "lower", "above", "upper", and the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device shown in the drawing is turned over, the device positioned "below" or "beneath" another device may be placed "above" another device. Accordingly, the illustrative term "below" may include both the lower and upper positions. The device may also be oriented in the other direction, and thus the spatially relative terms may be interpreted differently depending on the orientations.

Throughout the specification, when an element is referred to as being "connected" to another element, the element is "directly connected" to the other element, or "electrically connected" to the other element with one or more intervening elements interposed therebetween. It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

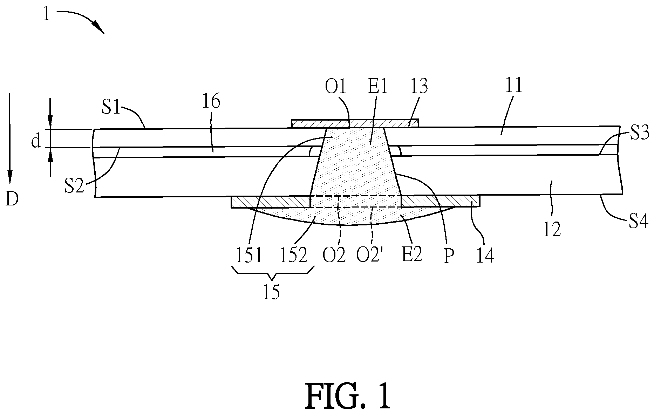

Hereinafter, an electronic device according to one embodiment of the present invention will be described with reference to FIG. 1 described as followed.

An electronic device 1 includes a first substrate 11, a second substrate 12, a plural of the passages P, a plural of first contacts 13, a plural of second contacts 14, and a plural of conductors 15.

The first substrate 11 defines a first face S1 and a second face S2 opposite to each other. The second substrate 12 defines a first face S3 and a second face S4 opposite to each other; the first face S3 of the second substrate 12 is adjacent to the second face S2 of the first substrate 11. In one case, the first face S3 of the second substrate 12 contacts the second face S2 of the first substrate 11 in a direct manner, such as electrostatic-driven lamination or vacuum lamination approaches. In one case, the first face S3 of the second substrate 12 connects the second face S2 of the first substrate 11 through additional material(s), such as an adhesion layer 16 which may be or include a material of non-conductive polymer. In one embodiment, the first or the second substrate 11, 12 is a resilient board, a rigid board, or a composite board including at least one of them. For more details, the quantity of the first substrate or/ and the second substrate is plural. In one embodiment, the first substrate 11 is of a thickness "d", which is equal to or less than 0.5 millimeter, or even equal to or less than 0.2 millimeter. In one case, the thickness of the first substrate 11 is less than that of the second substrate 12.

The passages P defines a first opening O1 and a second opening O2 opposite to each other; the first opening O1 of one of the passages P is formed at the first substrate 11, while the second opening O2 of the corresponds one of the passages P is formed at the second substrate 12. In this case, the first opening O1 of one of the passages P is formed at the first face S1 of the first substrate 11, while the second opening O2 of the corresponds one of the passages P is formed at the second face S4 of the second substrate 12. In one case, the first opening O1 and the second opening O2 of the corresponding one of the passage P defines different diameter. In one case, the first opening O1 and the second opening O2 of the corresponding each of the passage P defines different diameter. In one case, one or ones of the passage P defines a uniform diameter. In one case, the passages P are tapered gradually from the second substrate 12 to the first substrate 11. To be noted, the passages P would pass through the adhesion layer 16 as well, if the adhesion layer 16 exists or exists in a continuous manner. In more details, the passages P are optionally formed before or after the combination of the first and second substrates 11, 12. For example in one case, the passages P are formed after the combination of the first and second substrates 11, 12. In one case, partial portion of the passages P are formed on the first substrate 11 in advance, and the rest partial portion of the passages P are formed on the second substrate 12 before or after the combination of the first and second substrates 11, 12.

The first contacts 13 are arranged on the first face S1 of the first substrate 11, and one of the first contacts 13 is concealing the first opening O1 of the corresponding one of the passages P. In more details, the area of the first contacts 13 would properly be no less than the area of the first opening O1. In one case, the thickness of the first contacts 13 per se is greater than the thickness of traces, which is not illustrated and is usually arranged on the first surface S1 and electrically connected to the first contacts 13. The second contacts 14 are arranged on the second face S4 of the second substrate 12, and one of the second contacts 14 is adjacent to the second opening O2 of the corresponding one of the passages P. In one case, the second contacts 14 is set just by the second opening O2 of the corresponding one of the passages P. In one case, the second contact 14 could surround the second opening O2 of the corresponding one of the passages P in a continuous or non-continuous manner In one embodiment, one of the second contacts 14 at least partially embracing the second opening O2 of the corresponding one of the passages P. In one case, the second contacts 14 is disposed on the second face S4 of the second substrate 12 and is formed with a second opening O2' while the passage P is formed to pass through the second contact 14. To be noted, the second opening end of the passage P could be defined and identified as O2 or O2'. In one embodiment, the first substrate 11 includes a conductive pattern layer, and one or ones of the first contacts 13 are individually from and electrically connected the conductive pattern layer. In one embodiment, the first substrate 11 includes a conductive pattern layer, and one or ones of the first contacts 13 are partial of the conductive pattern layer. In one embodiment, the conductive pattern layer could be formed on the first face S1 of the first substrate 11, in the first substrate 11 or formed on the second face S2 of the first substrate 11. In one embodiment, the second substrate 12 includes a conductive trace layer, and ones of the second contacts 14 individually from and electrically connect the conductive trace layer. In one embodiment, the second substrate 12 includes a conductive trace layer, and one or ones of the second contacts 14 are partial of the conductive pattern layer. In one embodiment, the conductive trace layer could be formed on the first face S3 of the second substrate 12, in the second substrate 12 or formed on the second face S4 of the second substrate 12. To be noted, the first and second contacts 13, 14 and traces, which are optionally arranged on the first and second substrate 11, 12, could be made of same or difference materials, and also could be made by at least one layer of same or difference materials. In one embodiment, the conductive pattern layer of the first substrate 11 defines a thickness no greater than 1/4 mil; in one embodiment, one or ones of the first contacts 13 defines a thickness no less than the thickness of the conductive pattern layer; in one embodiment, a gap (not shown) is defined between a bottom concave surface of one or ones of the first contacts 13 and the first face S1 of the first substrate 11, the bottom concave surface of one or ones of the first contacts is higher than the first face S1 of the first substrate in a longitudinal direction along a corresponding one of the passages P, especially after the passages P are formed of laser processing, at the time the one or ones of the first contacts 13 with bottom concave surface could be treated with thickening process.

The conductors 15 are disposed in the passages P, and reach to the first surface S1 of the first substrate 11 at most. Each of the conductors 15 defines a first end 151 and a second end 152 opposite to each other; the first end 151 of one of the conductors 15 electrically connects the corresponding one of the first contacts 13, while the second end 152 of the corresponding one of the conductors 15 electrically connects the corresponding one of the second contacts 14. In one embodiment, the second end 152 partially covers the corresponding one of the second contacts 14 for electrical connection. In one embodiment, the conductors 15 include a material of tin, copper, silver, or gold, or an alloy or an intermetallic compound including any or any combination of the foregoing materials. In one case, one of the conductors 15 defines a first diameter portion E1, and a second diameter portion E2 connects the first diameter portion in a direct or indirect manner. In one case, first diameter portion E1 and a second diameter portion E2 are formed of the same material. In one case, the first diameter portion E1 and a second diameter portion E2 are formed with integrity, the first diameter portion E1 disposed in a corresponding one of the passages and connects the corresponding one of the first pads 13 to the second diameter portion E2, while the second diameter portion E2 rests on the second face S4 of the second substrate 12 and electrically connects the corresponding one of the second contacts. A diameter of the second diameter portion E2 is equal to or greater than a diameter of the first diameter portion E1. In one case, the second diameter portion E2 is greater than the second opening O2 of corresponding one or ones of the passages P, and partially covers the corresponding one or ones of the second contacts 14. In more details, the first contacts 13 or/and second contacts 14 could be implemented either before or after the conductors 15 are formed, and the conductors 15 are formed by pasting, jetting, printing or processes the like. The first and second substrates 11, 12 are individual and eclectically isolated from each other, and the connection between the two substrates 11, 12 due to the conductors 15 and the passages P benefits of easy implementation and budget manufacture; in one case, no contacts, pads, traces or lines between the two substrates 11, 12 maybe existed, in which a faster connection process is provided.

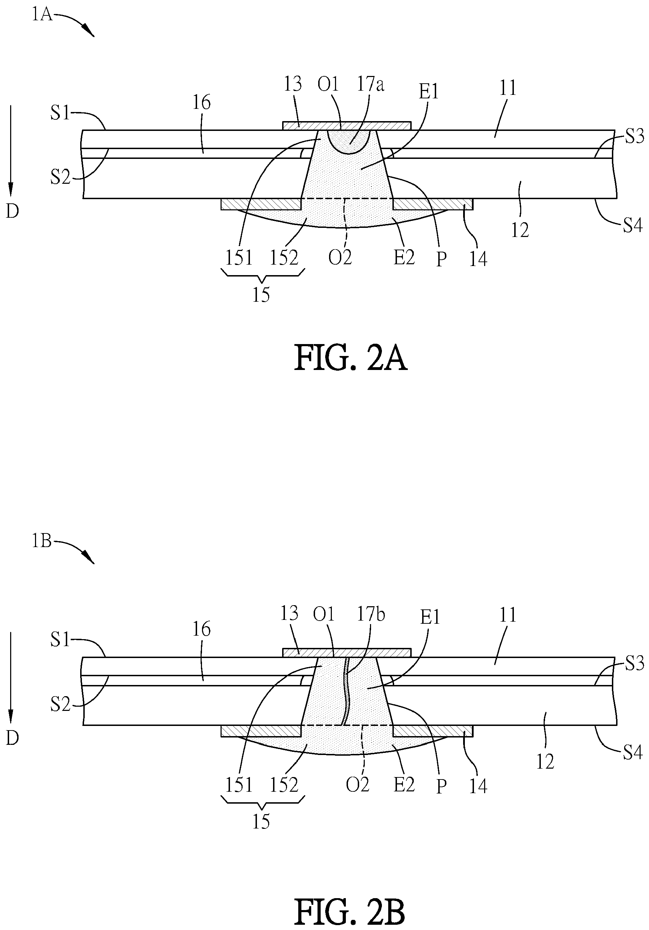

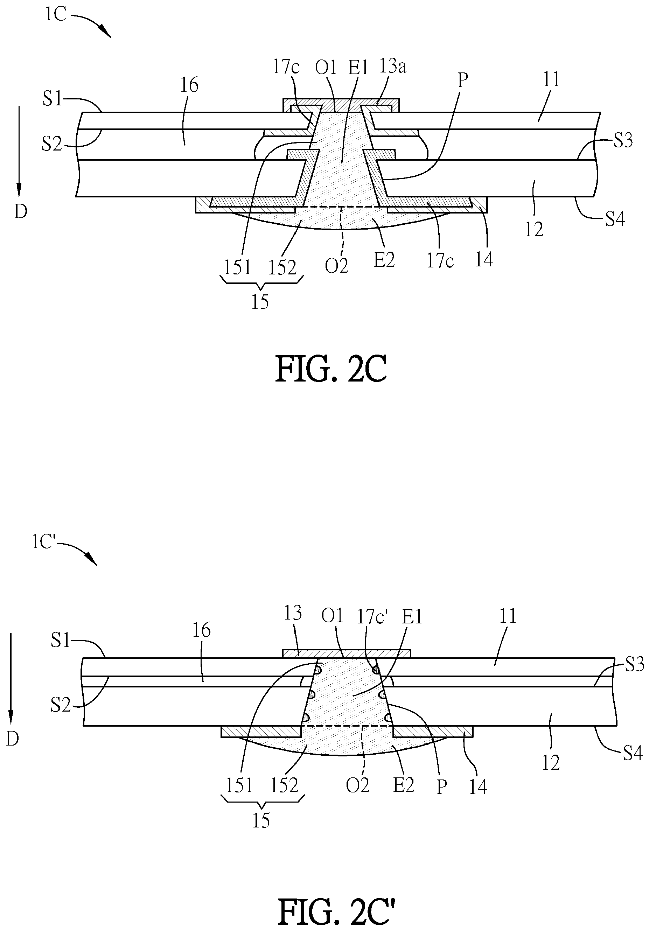

FIGS. 2A to 2C' illustrate embodiments of the electronic devices 1A to 1C' with an adjunctive member further comprised to be disposed in the corresponding one of the passages P.

In FIG. 2A, an adjunctive member is a bump 17a disposed at and beneath the corresponding one of the first contacts 13. It could be implemented by steps with: the first substrate 11 is formed with holes concealed by the first contacts 13. The bump 17a is then disposed on to the face of the first contact 13 which faces the holes, the first substrate 11 and the second substrate 12 are connected to each other to further formed the passages P, and the conductor 15 is disposed in the passage P and grasps the bump 17a. In this case, the hole is part of the passage P. There could be other steps to form the bump 17a before the first substrate 11 and the second substrate 12 connects to each other. In one case, the first contacts 13 could be treated as a planer surface, such as plating, electroless plating, sputtering, or the processes the like, after the holes (passages P) are penetrated, to form at least one conductive layer, as the bump 17a, stacked from the first contacts 13. The passages P are then filled by printing process, the conductors 15 are formed thereby. In addition, there are some chances as the conductive materials forming the bump 17a drops within the corresponding one of the passages P, the conductivity among the first contact 13, the second contact 14, and the conductor 15 may be improved thereby.

In FIG. 2B, an adjunctive member is a wire 17b received in the corresponding one of the passages P. It could be implemented by steps with: the first substrate 11 and the second substrate 12 are connected to each other in advance; the passages P is then formed through the first substrate 11 and the second substrate 12 and concealed by the first contact 13; the wire 17b is disposed inside the passage P; and the conductor 15 is disposed in the passage P and climbing along the wire 17b.

In FIG. 2C, an adjunctive member is attached onto at least one passage wall, wherein the passage wall could be part of the first substrate 11, the second substrate 12, or both, and each passage P is defined by the passage wall. In this case, the adjunctive member is a plating layer 17c continuously spread all over the passage wall and may be implemented during the step, such as a plating-through-hole process. In one case, the adjunctive member may further cover the second face S2 of the first substrate 11 in the plating-through-hole process. In this case, the plating layer 17c may further cover at least one of the first face S3 and the second face S4 of the second substrate 12 in the plating-through-hole process. It could be implemented by steps with: the first substrate 11 or/and the second substrate 12 are formed with holes. In this case, the hole on the first substrate 11 may be concealed by the first contacts 13 after the plating, but not limited thereto; the plating layer 17c are then formed onto the passage wall of the first substrate 11 which defines the passage as well by the plating-through-hole process; the first substrate 11 and the second substrate 12 are connected to each other to further formed the passages P; and the conductor 15 is disposed in the passage P after the first substrate 11 and the second substrate 12 connected with each other, and is attached onto the plating layer 17c arranged along the passage wall. There could be other steps to form the plating layer 17c before the first substrate 11 and the second substrate 12 connects to each other.

In FIG. 2C', an adjunctive member includes a plural of protrusions 17c' attached onto at least one passage wall, wherein the passage wall could be part of the first substrate 11, the second substrate 12, or both, and each passage P is defined by the passage wall. In one case, the adjunctive member is either conductive or not. It could be implemented by steps with: the first substrate 11 is formed with holes concealed by the first contacts 13; the protrusions 17c' are then disposed on to the passage wall of the first substrate 11 which defines the passage as well; the protrusions 17c' are disposed on to the passage wall of the second substrate 12; the first substrate 11 and the second substrate 12 are connected to each other to further formed the passages P; and the conductor 15 is disposed in the passage P and grips the protrusions 17c' along the passage wall. There could be other steps to form the protrusions 17c' before the first substrate 11 and the second substrate 12 connects to each other.

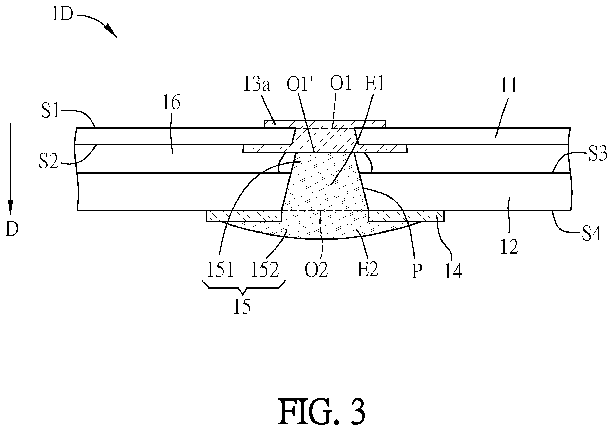

FIG. 3 illustrate embodiments of the electronic device 1D with different first contact 13a. The first substrate 11 is formed with a through hole, and the first contact 13a is disposed within the through hole and covers either one face or both faces S1, S2 of the first substrate 11. In this case, the first contact 13a is disposed within the through hole and covers both faces S1, S2 of the first substrate 11, the first contact 13a conceals the first opening O1' while the first opening O1' of one of the passages P is formed behind the first face S1 or even second face S2 of the first substrate 11. To be noted, the first opening end of the passage P could be defined and identified as O1 or O1'. The conductor 15 is disposed in the passage P after the first substrate 11 and the second substrate 12 connected with each other. To be noted, it is treated to stack and increase the thickness of the first contact 13a. The conductive materials forming the first contact 13a may drop within the corresponding one of the passages P to improve the conductivity.

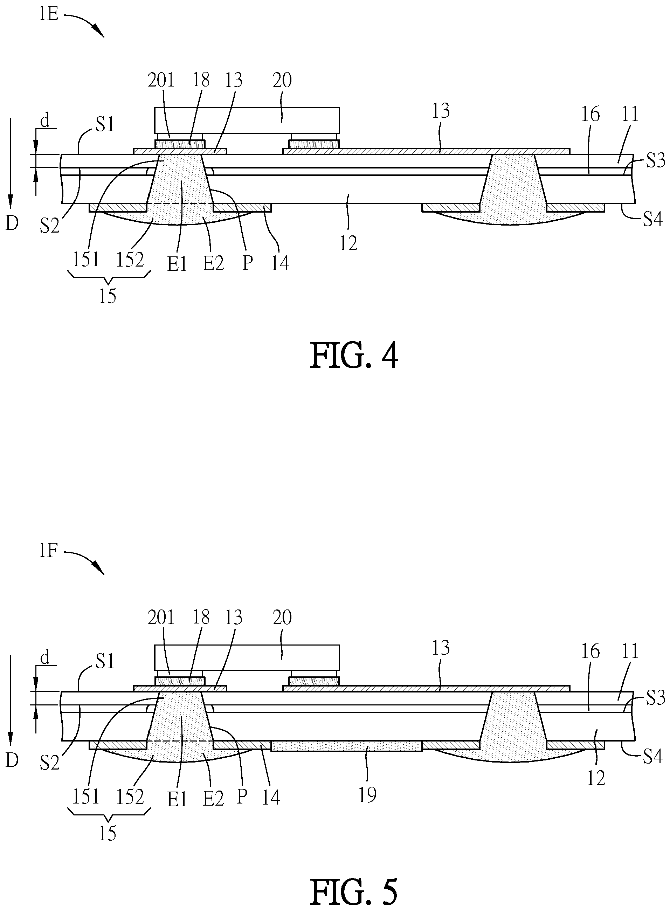

FIG. 4 illustrate embodiments of the electronic device IE, an electronic component 20 is further comprised on the first face S1 of the first substrate 11, wherein the electronic component electrically connects the corresponding one of the first contacts 13. In one embodiment, the electronic component 20 is on or under the level of millimeter or micro-meter scale. In one case, one of the first contacts 13 is a pad for electrically connecting an electrode 201 of the electronic component 20. In this case, the electrode 201 of the electronic component 20 electrically connect the corresponding one of the first contacts 13 through a conductive material 18, such as solder, gold, silver, or equivalents the like. In some case, the electrode 201 of the electronic component 20 electrically connect the corresponding one of the first contacts 13 without the conductive material 18 so as to form intermetallic compounds by processes, such as through the heat by heating or lasering, or equivalents the like. In one embodiment, the electronic component 20 could be an active component, such as TFT or IC, alternatively could be a varactor, a capacity, an encoder, a filter, a photoelectrical member, an optoelectronic member, an electro-optical member, a sensor, a piezo member, an antenna member, RF components or microwave (or millimeter wave), or others.

FIG. 5 illustrate embodiments of the electronic device 1F, based on the electronic device IE, further an active member 19 is disposed thereon and electrically connect to the conductors 15, in which the active member 19 connects to the corresponding one of the conductors 15 through one of the second contacts 14. The active member 19 could be optionally disposed on at least one of the first and the second faces S1, S2 of the first substrate 11 and the first and the second faces S3, S4 of the second substrate 12. In one case, the active member 19 is on the first face S1 of the first substrate 11. In one case, the active member 19 is on one of an additional substrate, other than the first and second substrates 11, 12, in which the additional substrate could be a COF (chip on film), FPC (Flexible Printed Circuit), or the like. In one case, the active member 19 is on the second substrate 12 and at least partially overlaps one of the electronic components 17 in a direction "D" vertical to the first substrate 11.

In one embodiment, the quantity of either element could be arranged in plural, such as the quantity of the electronic component 17 is plural, the quantity of the active member 19 is plural, the quantity of the adhesion layer 16 is plural, the quantity of the first substrate 11 is plural. When the quantity of the first substrate 11 is plural, the quantity of the adhesion layer 16 could be one or plural for attachment thereto. When the quantity of the electronic component 17 is plural, the quantity of the active member 19 could be one or plural for correspondence thereto.

A manufacture method for the foresaid electronic device according to the present invention, comprising a step of providing a first and a second substrates 11, 12, on which one or more passages P formed through the first and the second substrates 11, 12 and one or more first and second pads 13, 14 respectively disposed thereon, and a step of electrically connecting the first and the second substrates 11, 12. In the step of providing the first and the second substrates 11, 12, the first substrate 11 is defined with a first face S1 and a second face S2 opposite to each other; the second substrate 12 is defined with a first face S3 and a second face S4 opposite to each other; the first face S3 of the second substrate 12 is adjacent to the second face S2 of the first substrate 11; each of the passages P is defined with a first opening O1 and a second opening O2 opposite to each other; the first opening O1 of one of the passages P is formed at the first face S1 of the first substrate 11, while the second opening O2 of the corresponding one of the passages P is formed at the second face S4 of the second substrate 12; the first contacts 13 are arranged on the first face S1 of the first substrate 11, and one of the first contacts 13 is concealing the first opening O1 of the corresponding one of the passages P; and the second contacts 14 are arranged on the second face S4 of the second substrate 12, and one of the second contacts 14 is adjacent to the second opening O2 of the corresponding one of the passages P. In the step of electrically connecting the first and the second substrates 11, 12, one or more conductors 15 are disposed in one or more of the passages P, and the conductors 15 are made of the same materials, and furthermore are made of one single conductive material; each of the conductors 15 is defined with a first end 151 and a second end 152 opposite to each other; the first end 151 of one of the conductors 15 electrically connects the corresponding one of the first contacts 13, while the second end 152 of the corresponding one of the conductors 15 electrically connects the corresponding one of the second contacts 14. In the step of providing the first and the second substrates 11, 12, the first and the second substrates 11, 12 are electrically isolated from each other.

In the step of providing the first and the second substrates 11, 12, the first and the second substrates 11, 12 are connected to each other and then penetrating the first and the second substrates 11, 12 to form the passages P. For more details, the first and the second substrates 11, 12 are penetrating together to form the passages P at one time by laser processing. In this case, the high-density arrangement of pads 13 (components) on the first face S1 of the first substrate 11 would be approached due to high precision of the passage alignment between the first and the second substrates 11, 12. In the step of providing the first and the second substrates 11, 12, the first and the second substrates 11, 12 are respectively formed with one or more holes (without numerals) and then connected with each other, in which the holes formed on the first substrate 11 and the holes formed on the second substrate 12 are kept aligned with each other to form the passages P. For more details, the first and the second substrates 11, 12 are penetrating individually to form the holes by laser processing.

In the step of electrically connecting the first and the second substrates 11, 12, the conductors 15 are disposed in the passages P to electrical connect the first contacts 13 and the second contacts 14 at the same time, which are formed by pasting, jetting, printing or processes the like.

The devices according to embodiments of the present disclosure are advantageous of high-density arrangement of components on the first face S1 of the first substrate 11, because the layout of the conductors 15, with the holes (as passages P in this disclosure), on the first face S1 of the first substrate 11 could be omitted. The conductors 15 are hidden by ones of the first contacts 13 and still keep the electrical connection between the layout on the first substrate 11 and the layout on the second substrate 12. Furthermore, the conductors 15 are restrained in the passages P so as to keep the great connection uniformity between the first and the second substrates 11, 12, in comparison with the conventional SMT with the solder applied between the first and the second substrates 11, 12. In addition, the first substrate 11 and the second substrate 12 are individually from each other, on which various functions are provided and relative components are disposed; one of the benefits is that the connection structure applied between the first substrate 11 and the second substrate 12 is easy implementation and budget manufacture. It results in the possibility of forming highly flexible various functional electronic devices under the requirement of high-density arrangement. It also brings up some benefits, in condition as the electronic components are LEDs, the display quality of the electronic device, a display in this case, would be great due to great connection uniformity between the first and the second substrates 11, 12.

It should be understood that additional operations can be provided before, during, and after the method, and some of the operations described can be replaced or eliminated for other embodiments of the method.

From the foregoing, it will be appreciated that various embodiments in accordance with the present disclosure have been described herein for purposes of illustration, and that various modifications may be made without departing from the scope and spirit of the present teachings. Accordingly, the various embodiments disclosed herein are not intended to be limiting of the true scope and spirit of the present teachings.

While the disclosure has been described by way of example and in terms of embodiment, it should be understood that the disclosure is not limited thereto. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An electronic device, comprising:
a first substrate defined with a first face and a second face opposite to each other;
a second substrate defined with a first face and a second face opposite to each other, wherein the first face of the second substrate is adjacent to the second face of the first substrate;
a plural of passages, wherein each of the passages is defined with a first opening and a second opening opposite to each other, and the first opening of one of the passages is formed at the first substrate, while the second opening of the corresponding one of the passages is formed at the second substrate;
a plural of first contacts arranged on the first face of the first substrate, wherein one of the first contacts conceals the first opening of the corresponding one of the passages;
a plural of second contacts arranged on the second face of the second substrate, wherein one of the second contacts is adjacent to the second opening of the corresponding one of the passages; and
a plural of conductors disposed in the passages, wherein each of the conductors is defined with a first end and a second end opposite to each other, and the first end of one of the conductors electrically connects the corresponding one of the first contacts, while the second end of the corresponding one of the conductors electrically connects the corresponding one of the second contacts.

2. The electronic device of claim 1, further comprising an electronic component arranged on the first face of the first substrate, wherein the electronic component electrically connects the corresponding one of the first contacts.

3. The electronic device of claim 1, wherein the first substrate or/and the second substrate is a resilient board, a rigid board, or a composite board including at least one of a resilient board and a rigid board.

4. The electronic device of claim 1, wherein the first substrate is of a thickness equal to or less than 0.5 millimeter.

5. The electronic device of claim 1, wherein the first substrate includes a conductive pattern layer, and the conductive pattern layer defines a thickness no greater than 1/4 mil.

6. The electronic device of claim 1, further comprising an adjunctive member disposed in the corresponding one of the passages.

7. The electronic device of claim 1, further comprising an adhesion layer connected between the first substrate and the second substrate.

8. The electronic device of claim 1, wherein one of the conductors is defined with a first diameter portion and a second diameter portion connected to the first diameter portion; a diameter of the second diameter portion is equal to or greater than that of the first diameter portion; the first diameter portion disposed in a corresponding one of the passages and connects the corresponding one of the first pads to the second diameter portion, while the second diameter portion rests on the second face of the second substrate and electrically connects corresponding one of the second contacts.

9. The electronic device of claim 1, wherein the quantity of the first substrate is plural.

10. An electronic device, comprising:
a first substrate defined with a first face and a second face opposite to each other;
a second substrate defined with a first face and a second face opposite to each other, wherein the first face of the second substrate is adjacent to the second face of the first substrate;
a plural of passages, wherein each of the passages is defined with a first opening and a second opening opposite to each other, and the first opening of one of the passages is formed at the first face of the first substrate, while the second opening of the corresponding one of the passages is formed at the second face of the second substrate;
a plural of first contacts arranged on the first face of the first substrate, wherein one of the first contacts conceals the first opening of the corresponding one of the passages;
a plural of second contacts arranged on the second face of the second substrate, wherein one of the second contacts is adjacent to the second opening of the corresponding one of the passages;
a plural of conductors disposed in the passages, wherein each of the conductors is defined with a first end and a second end opposite to each other, and the first end of one of the conductors electrically connects the corresponding one of the first contacts, while the second end of the corresponding one of the conductors electrically connects the corresponding one of the second contacts;
a plural of electronic components disposed on the first face of the first substrate, wherein one of the electronic components electrically connects the corresponding one of the first contacts; and
a plural of active members disposed on the first substrate or/and the second substrate and electrically connect to the conductors.
